# EUROPEAN PATENT APPLICATION

(11) **EP 2 129 205 A1**
(43) Date of publication of application: **02.12.2009**
(21) Application number: 09157685.0
(22) Date of filing: 09.04.2009
(51) Int. Cl.: H05K 7/20, H01L 23/40

(54) **Plasma display device**

(30) Priority: 27.05.2008 KR 20080049192
(71) Applicant: Samsung SDI Co., Ltd., Gyeonggi-do (KR)
(72) Inventor: Kim, Suk-Ki,. Samsung SDI Co., Ltd., Suwon-si, Gyeonggi-do (KR); Park, Jung-Pil, Samsung SDI Co., Ltd., Suwon-si, Gyeonggi-do (KR)
(74) Representative: Gulde Hengelhaupt Ziebig & Schneider

(57) **Abstract**

A display device includes a display panel for displaying an image, a chassis base for supporting the display panel and a heat dissipating plate at one side of the chassis base. The display device further includes a printed circuit board between the heat dissipating plate and the chassis base attached to the heat dissipating plate and electrically connected to the display panel, and a switch electrically connected to the printed circuit board to generate a signal for controlling the display panel, the switch being attached to the heat dissipating plate.

## Description

### BACKGROUND OF THE INVENTION

### (a) Field of the Invention

The present invention relates to a display device, and more particularly, to a plasma display device with a switch.

### (b) Description of the Related Art

Generally, a plasma display device includes a plasma display panel (PDP), a chassis base supporting the PDP, a plurality of printed circuit boards installed on the chassis base, and a front cover and a back cover combined with the chassis base to embed or house the above constituent elements.

As is well-known, the PDP displays an image using visible light of red (R), green (G), and blue (B) generated by exciting phosphors using vacuum ultra-violet (VUV) rays emitted from plasmas obtained by a gas discharge.

Among the plurality of printed circuit boards, a sustain board and a scan board include switches to generate signals to be applied to a sustain electrode and a scan electrode included in the PDP. Since the switch generates a high frequency voltage pulse signal, the switch generates intense heat during operation.

For example, one surface of the printed circuit board is installed on the rear surface of the chassis base and the other surface of the printed circuit board includes various types of electrical elements and the switch. In order to dissipate heat generated from the switch, a heat sink may be attached onto the switch. The switch and the heat sink protrude from the printed circuit board.

The heat sink may have some limitations on dissipating heat generated from the switch. In order to sufficiently dissipate the heat from the switch, the switch needs to be relatively large to increase the heat dissipation capacity.

Accordingly, the back cover provided on the chassis base covering the printed circuit board side is formed to provide sufficient space for accommodating the printed circuit board, the switch, and the heat sink, resulting in increased thickness of the plasma display device.

Further, since the switch is mounted on the printed circuit board toward the back cover, the switch emits electromagnetic interference (EMI) and noise to the outside of the back cover. Consequently, operation of the switch increases EMI and noise.

The above information disclosed in this Background section is only for enhancement of understanding of the background of the invention and therefore it may contain information that does not form the prior art that is already known to a person of ordinary skill in the art.

### SUMMARY OF THE INVENTION

Embodiments of the present invention provide a plasma display device having advantages of reducing electromagnetic interference (EMI) and noise, and also improving heat dissipation performance of a switch and minimizing a thickness of a plasma display panel.

According to aspects of the present invention, a display device includes a display panel for displaying an image, a chassis base for supporting the display panel and a heat dissipating plate at one side of the chassis base. The display device further includes a printed circuit board between the heat dissipating plate and the chassis base attached to the heat dissipating plate and electrically connected to the display panel, and a switch electrically connected to the printed circuit board adapted to generate a driving signal for controlling the display panel. According to the invention the switch is attached to the heat dissipating plate.

In one embodiment, the chassis base further includes a plurality of bosses, wherein the heat dissipating plate is installed on the plurality of bosses. Further, the heat dissipating plate may include a plurality of bosses adapted to support the printed circuit board and an installation hole aligned with the switch.

The printed circuit board may include a first circuit pattern facing the chassis base and a second circuit pattern facing the heat dissipating plate, and the switch may be electrically connected to the second circuit pattern. The printed circuit board may include a penetration hole aligned with the installation hole of the heat dissipating plate.

A heat sink may be on an outer surface of the heat dissipating plate or on the inner surface of the heat dissipating plate on which the switch is installed. The switch may also be arranged between the inner surface of the heat dissipating plate and the heat sink.

In one embodiment, the heat dissipating plate includes a plane portion generally parallel to the chassis base, a side portion curved from the plane portion toward the chassis base, and a flange curved from the side portion to be parallel to the plane portion and proximate an outer edge of the chassis base. The switch may be installed on an inner surface of the side portion and the display device may further include a heat sink on an outer surface of the side portion. In one embodiment, the switch is a dual in-line package (DIP) type. In yet another embodiment the display panel is a plasma display panel. The printed circuit board may be a scan board comprising a scan electrode driver or a sustain board comprising a sustain electrode driver.

### BRIEF DESCRIPTION OF THE DRAWINGS

FIG. 1 is an exploded perspective view of a plasma display device according to a first embodiment of the present invention.
FIG. 2 is a cross-sectional view taken along the line - of FIG. 1.
FIG. 3 is a cross-sectional view of a plasma display device according to a second embodiment of the present invention.
FIG. 4 is a partial exploded perspective view of a printed circuit board, a switch, and a heat sink shown in FIG. 3.
FIG. 5 is a cross-sectional view of a plasma display device according to a third embodiment of the present invention.
FIG. 6 is a cross-sectional view of a plasma display device according to a fourth embodiment of the present invention.

### DETAILED DESCRIPTION

In the following detailed description, only certain embodiments of the present invention have been shown and described, simply by way of illustration. As those skilled in the art would realize, the described embodiments may be modified in various different ways, all without departing from the scope of the present invention. The drawings and description are to be regarded as illustrative in nature and not restrictive. Like reference numerals designate like elements throughout the specification.

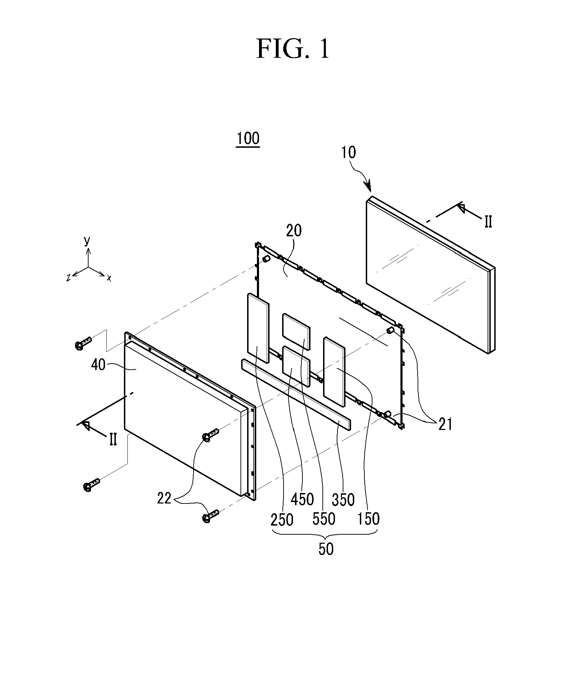

FIG. 1 is an exploded perspective view of a plasma display device 100 according to a first embodiment of the present invention.

Referring to FIG. 1, the plasma display device 100 includes a plasma display panel (PDP) 10 for displaying an image, a chassis base 20, a heat dissipating plate 40, and a plurality of printed circuit boards 50.

The chassis base 20 supports the PDP and is attached to an opposite side of the PDP 10 from the display side of the PDP 10. The heat dissipating plate 40 is disposed at and attached to the rear of the chassis base 20. As such, the chassis base 20 includes a plurality of bosses 21 separated from each other for receiving the heat dissipating plate 40. The heat dissipating plate 40 may be fastened to the bosses 21 by screws 22 or by other suitable fasteners.

The printed circuit boards 50 are disposed between the chassis base 20 and the heat dissipating plate 40 and attached to the heat dissipating plate 40. Also, the printed circuit boards 50 may be electrically connected to the PDP 10 to operate the PDP 10.

The present embodiment is primarily directed to the relationship between the heat dissipating plate 40 and the printed circuit board 50. Therefore, further detailed descriptions about the PDP 10 and the printed circuit board 50 will be omitted herein.

For better comprehension and ease of description, the PDP 10 includes electrodes for gas discharge, for example, a sustain electrode (not shown), a scan electrode (not shown), and an address electrode (not shown).

A plurality of the printed circuit boards 50 may be formed to share and perform functions of driving the PDP 10. For example, the printed circuit boards 50 may include a sustain board 150 controlling the sustain electrode, a scan board 250 controlling the scan electrode, and an address buffer board 350 controlling the address electrode.

Further, the printed circuit boards 50 include an image processing/controlling board 450 and a power supply board 550. The image processing/controlling board 450 functions to receive an image signal to generate each control signal for driving the address electrode, the sustain electrode, and the scan electrode, and to apply the generated control signals to corresponding boards. The power supply board 550 functions to supply power required for driving the boards.

Among the printed circuit boards 50, the sustain board 150 and the scan board 250 include a switch 60 for driving the sustain electrode and the scan electrode. However, if the address buffer board 350, the image processing/controlling board 450, and/or the power supply board 550 are mounted with a separate electrical device needing heat dissipation, embodiments of the present invention may also be applicable in those cases.

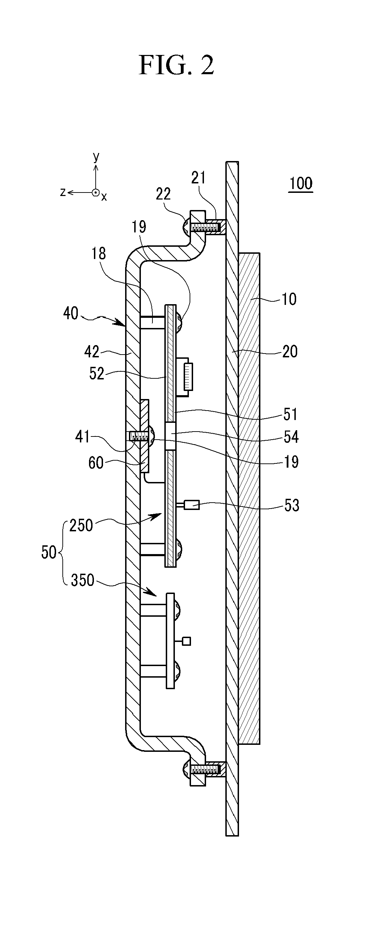

FIG. 2 is a cross-sectional view taken along line - of FIG. 1. With reference to FIG. 2, the present exemplary embodiment will be described on the basis of, for example, the scan board 250 controlling the scan electrode only, for convenience. The scan board 250 includes a scan integrated circuit (IC) generating a high frequency scan pulse to be applied to the scan electrode. The scan IC is an example of the switch 60 in accordance with the present embodiment.

The scan board 250 is disposed between the chassis base 20 and the heat dissipating plate 40, and is fixed to a plurality of bosses 18 by screws 19. The plurality of bosses 18 are formed on the inner surface of the heat dissipating plate 40. In this instance, the scan board 250 is generally parallel to the heat dissipating plate 40 and the chassis base 20.

The switch 60 is electrically connected to the scan board 250 and fixed to a plane portion 42 of the heat dissipating plate 40. The heat dissipating plate 40 has an installation hole 41 facing the switch 60 to allow a fastener to fasten the switch to the heat dissipating plate.

The scan board 250 may have a double-sided circuit pattern structure including a first circuit pattern 51 that faces the chassis base 20 and a second circuit pattern 52 that faces the heat dissipating plate 40.

Most electrical devices 53 are mounted onto the first circuit pattern 51 and the switch 60 is connected to the second circuit pattern 52. For example, the switch 60 may be a dual in-line package (DIP) type and may be connected to the second circuit pattern 52.

Since the first circuit pattern 51 equipped with electrical devices 53 faces the chassis base 20, electromagnetic interference (EMI) and noise generally occurring between the first circuit pattern 51 and the electrical devices 53 of the scan board 250 may be blocked by the chassis base 20 and the scan board 250.

The switch 60 is mechanically installed to the heat dissipating plate 40 and is electrically connected to the second circuit pattern 52 of the heat dissipating plate 40. In this instance, the switch 60 contacts the inner surface of the heat dissipating plate 40.

Accordingly, the switch 60 attached to the heat dissipating plate 40 may quickly transfer the intense heat generated by the switch 60 during operation to the heat dissipating plate 40. Specifically, the heat dissipating plate 40 functions as a heat sink for the switch 60. Accordingly, the heat dissipation performance of the switch 60 may be improved.

A thermal grease may be further provided between the switch 60 and the inner surface of the heat dissipating plate 40. In this case, due to a heat transfer function of the thermal grease, the heat dissipation performance of the switch 60 is further improved.

According to the present embodiment, a separate and additional heat sink is not provided for the heat dissipation of the switch 60. Therefore, as compared to when an additional and separate heat sink is provided, it is possible to minimize a thickness (z-axis direction distance) of the plasma display device 100.

As described above, the scan board 250 has a penetration hole 54 facing and aligned with the installation hole 41 of the heat dissipating plate 40 such that the switch 60 may be attached to the heat dissipating plate 40 while being covered by the scan board 250.

Hereinafter, assembly of the plasma display device according to the present embodiment will be described.

With the switch 60 aligned with the installation hole 41, a driver (not shown) is inserted into the penetration hole 54 of the scan board 250, the screw 19 is inserted into the switch 60 and then screwed into the installation hole 41 of the heat dissipating plate 40. Accordingly, the switch 60 is fastened to the heat dissipating plate 40.

Next, the scan board 250 is mounted to the boss 18 formed in the heat dissipating plate 40. Accordingly, the scan board 250 is mounted to the heat dissipating plate 40.

Hereinafter, second, third, and fourth embodiments of the present invention will be described. Certain elements of the second, third, and fourth embodiments of the present invention are similar to or the same as the first embodiment, and therefore only the differences will be described in detail.

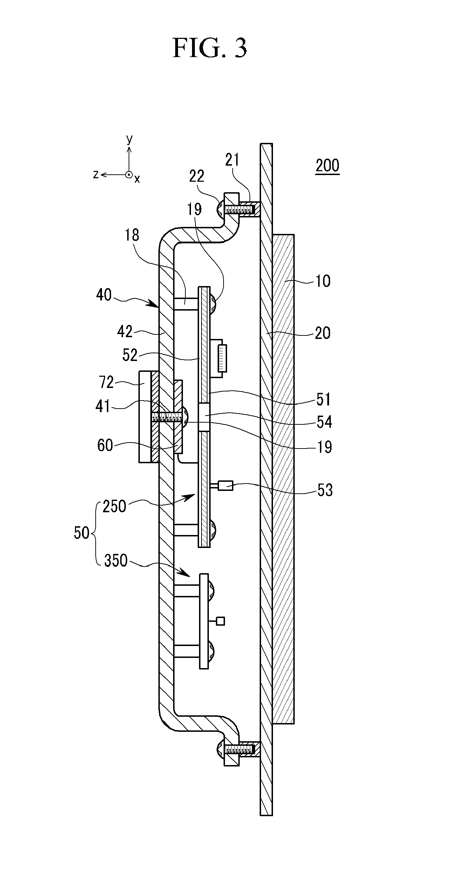

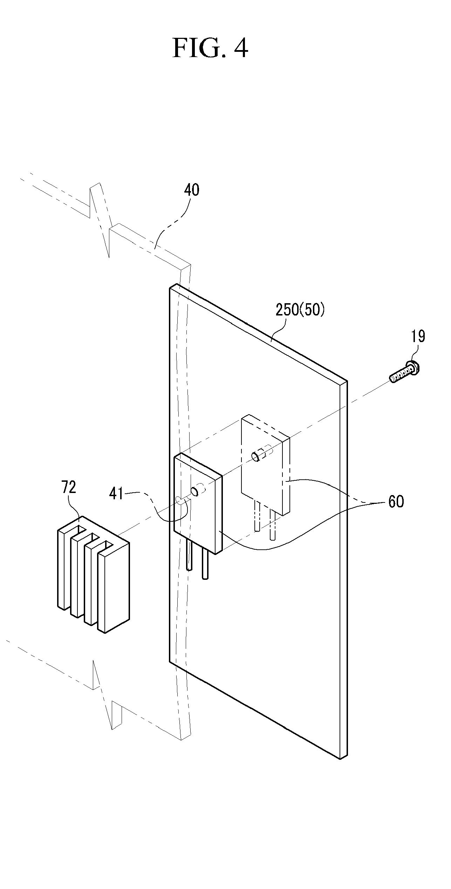

FIG. 3 is a cross-sectional view of a plasma display device 200 according to a second embodiment of the present invention, and FIG. 4 is a partial exploded perspective view of a printed circuit board, a switch, and a heat sink shown in FIG. 3.

Referring to FIGS. 3 and 4, the plasma display device 200 according to the second embodiment further includes a heat sink 72.

A switch 60 is installed on the inner surface of a heat dissipating plate 40 through an installation hole 41 and a screw 19. The heat sink 72 is installed on the outer surface of the heat dissipating plate 40, corresponding to the switch 60.

The heat sink 72 may protrude in the z-axis direction within a suitable range of space between the heat dissipating plate 40 and a back cover (not shown). Specifically, the heat sink 72 may be provided on the outer surface of the heat dissipating plate 40 within a range such that it protrudes without increasing the overall thickness (z-axis direction) of the plasma display device 200.

In one embodiment, the heat sink may include fins. With respect to thermal conductivity, the heat sink 72 dissipates more heat than the heat dissipating plate 40 alone. Thus, the intense heat generated by the switch 60 is more quickly dissipated through the heat sink 72 and a portion of the heat dissipating plate 40 corresponding to the switch 60.

Compared to the first embodiment, the second embodiment may increase the thickness (z-axis direction) of the plasma display device 200 due to the heat sink 72. However, it is possible to more quickly dissipate the heat generated by the switch 60 via the heat sink 72, and therefore, it is possible to prevent the heat from spreading over the heat dissipating plate 40.

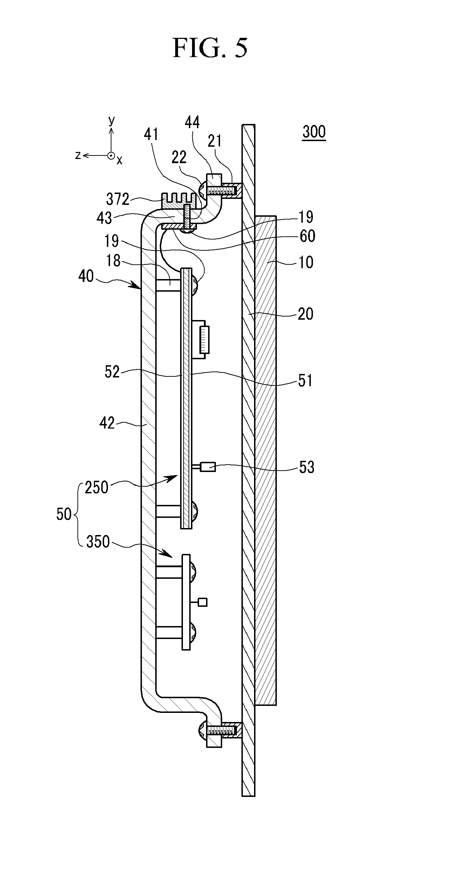

FIG. 5 is a cross-sectional view of a plasma display device 300 according to the third embodiment of the present invention.

Referring to FIG. 5, the plasma display device 300 according to the third embodiment includes a switch 60 and a heat sink 372 in different locations from previously described embodiments.

The heat dissipating plate 40 includes a plane portion 42, a side portion 43, and a flange 44 forming a 3-dimensional space for accommodating printed circuit boards 50, for example, a scan board 250.

The plane portion 42 is formed at the rear of the scan board 250 and is generally parallel to the scan board 250 and a chassis base 20. Specifically, the plane portion 42 defines the rearmost part of the heat dissipating plate 40.

The side portion 43 is curved from the plane portion 42 toward the chassis base 20. Specifically, the side portion 43 defines the side of the heat dissipating plate 40 and is generally perpendicular to the plane portion 42.

The flange 44 is curved from the side portion 430 and parallel with the plane portion 42 generally corresponding to the outer edge of the chassis base 20. The flange 44 is installed on the chassis base 20 to define the front of the heat dissipating plate 40.

With respect to the heat dissipating plate 40 constructed as above, the switch 60 may be installed on the inner surface of the side portion 43 and the heat sink 372 may be installed on the outer surface of the side portion 43 generally opposite the switch.

In the third embodiment, the switch 60 and the heat sink 372 are both installed on the side portion 43 of the heat dissipating plate 40. Therefore, it is possible to provide a structure that may further improve heat dissipation performance of the switch 60 and yet will not increase a thickness (z-axis direction thickness) of the plasma display device 300.

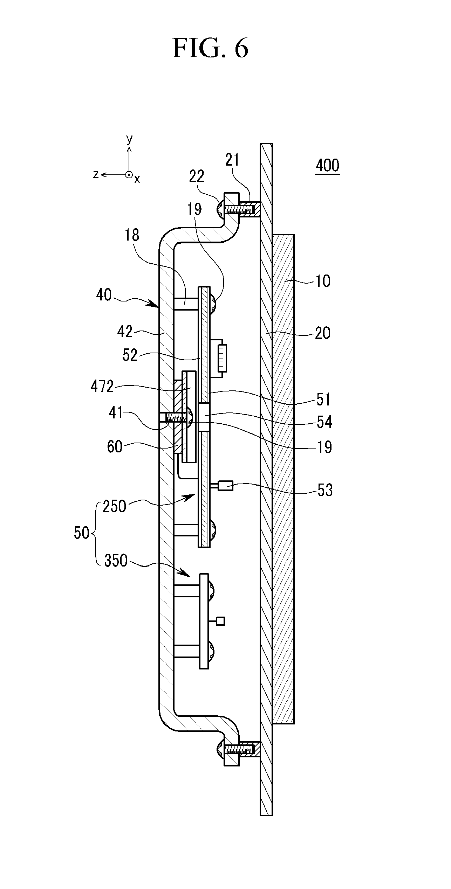

FIG. 6 is a cross-sectional view of a plasma display device 400 according to the fourth embodiment of the present invention. The plasma display device 400 generally corresponds to the plasma display device 200 according to the second embodiment.

A switch 60 is installed on the inner surface of a heat dissipating plate 40 via an installation hole 41 and a screw 19 and a heat sink 472 is installed on the switch 60. Specifically, the switch 60 is disposed between the inner surface of the heat dissipating plate 40 and the heat sink 472.

The heat sink 472 improves the heat dissipating performance of the switch 60, but does not protrude externally from the heat dissipating plate 40. Therefore, compared to the second embodiment, the thickness (z-axis direction thickness) of the plasma display device 400 is not increased.

In the first to the fourth embodiments, a single heat dissipating plate 40 generally corresponds to the single chassis base 20 to thereby integrally cover all the printed circuit boards 50. However, although not illustrated, the heat dissipating plate 40 may be formed to cover each of the printed circuit boards 50 individually.

While this invention has been described in connection with certain embodiments, it is to be understood that the invention is not limited to the disclosed embodiments, but, on the contrary, is intended to cover various modifications and equivalent arrangements included within the scope of the appended claims.

## Claims

1. A display device (100, 200, 300, 400) comprising:
a display panel (10) for displaying an image;
a chassis base (20) for supporting the display panel (10);
a heat dissipating plate (40) at one side of the chassis base (20);
a printed circuit board (250) between the heat dissipating plate (40) and the chassis base (20) attached to the heat dissipating plate (40) and electrically connected to the display panel (10); and
a switch (60) electrically connected to the printed circuit board (250) and adapted to generate a driving signal for controlling the display panel (10), **characterised in that** the switch is attached to the heat dissipating plate (40).

2. The display device (100, 200, 300, 400) of claim 1, the chassis base (20) including a plurality of bosses (21), wherein the heat dissipating plate (40) is installed on the plurality of bosses (21).

3. The display device (100, 200, 300, 400) of one of the claims 1 or 2, the heat dissipating plate (40) including a plurality of bosses (18) adapted to support the printed circuit board (250) and an installation hole (41) aligned with the switch.

4. The display device (100, 200, 300, 400) of claim 3, wherein the printed circuit board (250) includes a first circuit pattern (51) facing the chassis base (20) and a second circuit pattern (52) facing the heat dissipating plate (40), and
wherein the switch (60) is electrically connected to the second circuit pattern (52).

5. The display device (100, 200, 300, 400) of one of the claims 3 or 4, wherein the printed circuit board (250) includes a penetration hole (54) aligned with the installation hole (41) of the heat dissipating plate (40).

6. The display device (200, 300) of one of the preceding claims, further comprising a heat sink (72, 372) on an outer surface of the heat dissipating plate (40).

7. The display device (400) of one of the claims 1 through 5, further comprising a heat sink (472) on an inner surface of the heat dissipating plate (40) on which the switch (60) is installed.

8. The display device (400) of claim 7, wherein the switch is arranged between the inner surface of the heat dissipating plate (40) and the heat sink (472).

9. The display device (100, 200, 300, 400) of one of the preceding claims, wherein the heat dissipating plate (40) comprises:
a plane portion (42) generally parallel to the chassis base (20);
a side portion (43) curved from the plane portion (42) toward the chassis base (20); and
a flange (44) curved from the side portion (43) to be parallel to the plane portion (42) and proximate an outer edge of the chassis base (20).

10. The display device (300) of claim 9, wherein the switch (60) is installed on an inner surface of the side portion (43).

11. The display device (300) of claim 10, further comprising a heat sink (372) on an outer surface of the side portion (43).

12. The display device (100, 200, 300, 400) of one of the preceding claims, wherein the switch (60) is a dual in-line package (DIP) type.

13. The display device (100, 200, 300, 400) of one of the preceding claims, wherein the display panel (10) is a plasma display panel.

14. The display device (100, 200, 300, 400) of claim 13, wherein the printed circuit board (250) is a scan board comprising a scan electrode driver or a sustain board comprising a sustain electrode driver.
